# EUROPÄISCHE PATENTSCHRIFT

(11) **EP 2 147 245 B1**
(45) Veröffentlichungstag und Bekanntmachung des Hinweises auf die Patenterteilung: **10.12.2014**
(21) Anmeldenummer: 08758081.7
(22) Anmeldetag: 20.05.2008
(51) Int. Cl.: F21K 99/00, G02F 1/1335, H05K 1/02, H05K 1/18, H05K 3/00, F21S 4/00, F21Y 101/02

(54) **BELEUCHTUNSEINRICHTUNG, HINTERLEUCHTUNGSVORRICHTUNG UND ANZEIGEVORRICHTUNG**
LIGHTING DEVICE, BACKLIGHTING DEVICE, AND DISPLAY DEVICE
DISPOSITIF D'ÉCLAIRAGE, DISPOSITIF DE RÉTROÉCLAIRAGE ET DISPOSITIF D'AFFICHAGE

(30) Priorität: 22.05.2007 DE 102007023651
(43) Veröffentlichungstag der Anmeldung: 27.01.2010
(73) Patentinhaber: OSRAM GmbH, 80807 München (DE)
(72) Erfinder: BERTRAM, Ralph Peter, 93152 Nittendorf (DE); DUSSAULT, David, 93073 Neutraubling (DE); FIEGLER, Matthias, 82041 Deisenhofen (DE); STOYAN, Harald, 93191 Rettenbach (DE)
(74) Vertreter: Epping - Hermann - Fischer
(86) Internationale Anmeldenummer: PCT/DE2008/000838
(87) Internationale Veröffentlichungsnummer: WO 2008/141625

(56) Entgegenhaltungen:
- GB-A- 2 361 988
- US-A1- 2005 213 321
- US-A1- 2006 133 076

## Beschreibung

Diese Patentanmeldung beansprucht die Priorität der deutschen Patentanmeldung 102007023651.6, deren Offenbarungsgehalt hiermit durch Rückbezug aufgenommen wird.

Die Erfindung betrifft eine Beleuchtungseinrichtung, eine Hinterleuchtungsvorrichtung und eine Anzeigevorrichtung.

In der Druckschrift GB 2361988 A ist ein modulares Beleuchtungssystem mit einem Emitterstreifen bekannt, der gedruckte Leiterplatten enthält, auf den LEDs angeordnet sind. Zwischen benachbarten Leiterplatten sind Federverbinder angeordnet.

In der Druckschrift US 2005/213321 A1 ist ein Bauelement mit einer Mehrzahl von Lichtquellen beschrieben, wobei die Lichtquellen auf verschiedenen Trägern angeordnet sind und die Träger über Leiterbahnen miteinander elektrisch verbunden sind.

Die Druckschrift US 2006/0133076 A1 betrifft eine Randbeleuchtung mit einer Mehrzahl von Lichtquellen, wobei die Lichtquellen in einem langgestreckten und gekrümmten Rohr angeordnet sind.

Es ist eine Aufgabe der Erfindung, ein Konzept für die Gestaltung von Beleuchtungseinrichtungen mit einem Lichtmodul anzugeben, bei dem Beleuchtungseinrichtungen unterschiedlicher Größe und/oder Leuchtdichte mit gleichartigen Lichtmodulen herstellbar sind.

Diese Aufgabe wird durch eine Beleuchtungseinrichtung, eine Hinterleuchtungsvorrichtung und eine Anzeigevorrichtung gemäß den nebengeordneten Ansprüchen gelöst. Ausgestaltungen der Beleuchtungseinrichtung und der Anzeigevorrichtung sind jeweils in den abhängigen Ansprüchen angegeben.

Eine Beleuchtungseinrichtung gemäß der Erfindung weist mindestens ein Lichtmodul auf, das mindestens eine erste Gruppe von Lichtquellen und eine zweite Gruppe von Lichtquellen aufweist, die voneinander beabstandet auf einer flexiblen Leiterplatte angeordnet sind. Bei einer Ausgestaltung ist die flexible Leiterplatte streifenförmig. Bei einer weiteren Ausgestaltung weist das Lichtmodul drei oder mehr Gruppen von Lichtquellen auf, die zum Beispiel in einer Reihe auf der flexiblen Leiterplatte angeordnet sind.

Die Beleuchtungseinrichtung enthält weiter einen insbesondere starren Träger, an dem das Lichtmodul befestigt ist, und eine Pufferzone zwischen der ersten und der zweiten Gruppe von Lichtquellen, welche lateral mit dem Lichtmodul überlappt. Weist das Lichtmodul drei oder mehr in einer Reihe angeordnete Gruppen von Lichtquellen auf, enthält die Beleuchtungseinrichtung bei einer Weiterbildung zwischen je zwei benachbarten Gruppen eine Pufferzone. Die flexible Leiterplatte weist insbesondere im Bereich der Pufferzone eine Biegung und/oder Faltung auf. Bei einer Ausgestaltung ist die erste Gruppe von Lichtquellen in Draufsicht auf den Träger beispielsweise in einer Öffnung des Trägers angeordnet.

Eine Gruppe von Lichtquellen weist im vorliegenden Zusammenhang mindestens eine Lichtquelle auf. Vorzugsweise weist sie eine Mehrzahl von Lichtquellen auf. Die lateralen Abstände der Lichtquellen einer Gruppe von Lichtquellen untereinander sind insbesondere kleiner als der laterale Abstand zwischen der ersten und der zweiten Gruppe. Beispielsweise ist der laterale Abstand der ersten Gruppe von der zweiten Gruppe mindestens doppelt so groß wie der größte laterale Abstand zweier Lichtquellen innerhalb einer der Gruppen von Lichtquellen.

Bei einer Ausgestaltung weist die erste und/oder die zweite Gruppe von Lichtquellen mindestens eine Lichtquelle auf, die im Betrieb der Beleuchtungseinrichtung rotes, grünes, blaues oder weißes Licht emittiert. Bei einer Ausgestaltung ist die Beleuchtungseinrichtung dazu vorgesehen, weißes Licht zu emittieren. Bei einer solchen Ausgestaltung weisen beispielsweise die erste Gruppe von Lichtquellen und die zweite Gruppe von Lichtquellen jeweils mindestens eine Lichtquelle auf, die dazu vorgesehen ist, rotes Licht zu emittieren, eine Lichtquelle, die dazu vorgesehen ist, grünes Licht zu emittieren, und eine Lichtquelle, die dazu vorgesehen ist, blaues Licht zu emittieren. Alternativ oder zusätzlich kann die erste und/oder die zweite Gruppe von Lichtquellen eine Lichtquelle aufweisen, die dazu vorgesehen ist, weißes Licht zu emittieren.

Bei einer zweckmäßigen Ausgestaltung weist die flexible Leiterplatte im Bereich der Pufferzone eine Biegung und/oder eine Faltung auf. Beispielsweise weist die flexible Leiterplatte die Biegung und/oder Faltung an der Rückseite des Trägers auf. Bei einer Weiterbildung weist die flexible Leiterplatte zwischen der ersten und der zweiten Gruppe von Lichtquellen eine U-förmige Biegung auf. Anders ausgedrückt, beschreibt die flexible Leiterplatte im Verlauf von der ersten zur zweiten Gruppe von Lichtquellen - insbesondere an der Rückseite des Trägers - einen zunächst vom Träger weg und im weiteren Verlauf wieder auf den Träger zu laufenden Bogen.

Der Abstand zwischen der ersten und der zweiten Gruppe von Lichtquellen des Lichtmoduls ist mittels der Biegung und/oder Faltung der flexiblen Leiterplatte in der Pufferzone eingestellt. Auf diese Weise ist das gleiche Lichtmodul für Beleuchtungseinrichtungen geeignet, bei denen die erste und die zweite Gruppe von Lichtquellen unterschiedliche Abstände aufweisen. Beispielsweise wird die Größe der U-förmigen Biegung in Abhängigkeit vom lateralen Abstand der auf dem Träger vorgesehenen Montagepositionen für die erste und die zweite Gruppe von Lichtquellen gewählt. So sind Beleuchtungseinrichtungen mit unterschiedlicher Größe und/oder Leuchtdichte mit den gleichen Lichtmodulen herstellbar, so dass eine besonders kostengünstige Herstellung der Beleuchtungseinrichtung erzielt wird. Bei der Beleuchtungseinrichtung ist zudem ein besonders geringer Abstand der ersten und zweiten Gruppe von Lichtquellen und somit eine besonders hohe Leuchtdichte erzielbar.

Bei einer Ausgestaltung ist die Beleuchtungseinrichtung zur Emission von einer Vorderseite des Trägers vorgesehen und die flexible Leiterplatte verläuft im Bereich der Pufferzone zumindest stellenweise an einer der Vorderseite gegenüberliegenden Rückseite des Trägers. So ist beispielsweise die Gefahr verringert, dass die flexible Leiterplatte, insbesondere deren Biegung und/oder Faltung in der Pufferzone, von den Lichtquellen im Betrieb emittiertes Licht abschattet.

Bei einer Ausführungsform der Beleuchtungseinrichtung sind die erste und die zweite Gruppe von Lichtquellen auf einer Vorderseite des Trägers angeordnet. Bei einer Ausgestaltung dieser Ausführungsform weist der Träger im Bereich der Pufferzone eine Öffnung oder zumindest eine Vertiefung auf. Bei einer Beleuchtungseinrichtung mit einem Lichtmodul mit drei oder mehr in einer Reihe angeordnete Gruppen von Lichtquellen und je einer Pufferzone zwischen zwei benachbarten Gruppen, hat der Träger bei dieser Ausgestaltung eine Mehrzahl von Öffnungen beziehungsweise Vertiefungen, wobei jeweils eine Öffnung beziehungsweise Vertiefung zwischen zwei benachbarten Gruppen von Lichtquellen des Lichtmoduls angeordnet ist.

Insbesondere verläuft die flexible Leiterplatte durch die Öffnung zu einer der Vorderseite gegenüberliegenden Rückseite des Trägers. Zum Beispiel verläuft die flexible Leiterplatte ausgehend von der ersten Gruppe von Lichtquellen von der Vorderseite des Trägers durch die Öffnung hindurch zu der Rückseite des Trägers und im weiteren Verlauf zur zweiten Gruppe von Lichtquellen hin wieder durch die Öffnung des Trägers hindurch zu dessen Vorderseite zurück. Weist der Träger statt einer Öffnung eine Vertiefung auf, ist die Biegung und/oder Faltung der flexiblen Leiterplatte insbesondere teilweise oder vollständig in der Vertiefung enthalten.

Bei einer alternativen Ausführungsform ist in Draufsicht auf den Träger die erste Gruppe von Lichtquellen in einer Öffnung des Trägers angeordnet. Bei einer zweckmäßigen Ausgestaltung weist der Träger eine weitere Öffnung auf, in der die zweite Gruppe von Lichtquellen angeordnet ist. Die Pufferzone liegt bei dieser Ausgestaltung zweckmäßigerweise zwischen der Öffnung, in der die erste Gruppe von Lichtquellen angeordnet ist, und der weiteren Öffnung, in der die zweite Gruppe von Lichtquellen angeordnet ist. Enthält das Lichtmodul drei oder mehr Gruppen von Lichtquellen ist bei einer Ausgestaltung jeder Gruppe genau eine Öffnung des Trägers zugeordnet.

Bei einer Ausgestaltung dieser Ausführungsform ist zumindest die erste Gruppe von Lichtquellen an der Vorderseite des Trägers angeordnet. Die flexible Leiterplatte verläuft bei einer zweckmäßigen Ausgestaltung zumindest stellenweise an der Rückseite des Trägers. Insbesondere verläuft sie im Bereich der Pufferzone an der Rückseite des Trägers. Es ist auch denkbar, dass die erste Gruppe von Lichtquellen ebenfalls an der Rückseite des Trägers angeordnet ist und im Betrieb der Beleuchtungseinrichtung durch die Öffnung hindurch Licht zur Vorderseite des Trägers emittiert.

Bei einer Ausgestaltung weist die Beleuchtungseinrichtung mindestens einen Kühlkörper an der Rückseite des Trägers auf. Ist die erste Gruppe von Lichtquellen in der Öffnung des Trägers angeordnet, überlappt der Kühlkörper bei einer Weiterbildung der Beleuchtungseinrichtung lateral mit dieser und mit der Öffnung.

Bei einer weiteren Ausgestaltung ist das Lichtmodul mit dem Träger verklebt und/oder verklemmt. Bei einer Weiterbildung dieser Ausgestaltung ist die erste Gruppe von Lichtquellen mittels des Kühlkörpers mit dem Träger arretiert. Bei einer Weiterbildung ist die Öffnung des Trägers mittels des Kühlkörpers alternativ oder zusätzlich staubdicht verschlossen. Die Herstellung der Beleuchtungseinrichtung ist mittels der Montage des Lichtmoduls von der Rückseite des Trägers her und der Arretierung vermittels des Kühlkörpers besonders einfach und leicht automatisierbar.

Mindestens eine der Lichtquellen der ersten und/oder der zweiten Gruppe von Lichtquellen weist bei einer Ausgestaltung der Beleuchtungseinrichtung einen lichtemittierenden Halbleiterchip auf. Der lichtemittierende Halbleiterchip weist einen Halbleiterschichtstapel mit einem pn-Übergang, eine Doppelheterostruktur, eine Einfachquantentopfstruktur (single quantum well, SQW) oder eine Mehrfachquantentopfstruktur (multi quantum well, MQW) zur Strahlungserzeugung auf. Der Halbleiterschichtstapel basiert auf einem organischen und/oder einem anorganischen Halbleitermaterial. Bei einer Ausgestaltung handelt es sich um einen so genannten Dünnfilm-Halbleiterchip, bei dem der Halbleiterschichtstapel epitaktisch auf einem Aufwachssubstrat hergestellt, von diesem entfernt und mit der vom ursprünglichen Aufwachssubstrat abgewandten Seite auf einem Hilfsträgersubstrat montiert ist. Der Dünnfilm-Halbleiterchip weist höchstens noch einen dünnen Rest des ursprünglichen Aufwachssubstrats auf. Licht emittierende Halbleiterchips in Dünnfilmbauweise sind beispielsweise in den Druckschriften WO 92/13281 und EP 0905797 beschrieben, deren Offenbarungsgehalt hinsichtlich der Dünnfilmbauweise von Licht emittierenden Halbleiterchips hiermit ausdrücklich durch Rückbezug aufgenommen ist.

Bei einer Ausgestaltung ist der lichtemittierende Halbleiterchip in sogenannter "chip on board"-Technologie direkt an der flexiblen Leiterplatte befestigt, etwa mittels eines Lotes oder eines insbesondere elektrisch leitfähigen Klebstoffs.

Bei einer alternativen Ausgestaltung ist der lichtemittierende Halbleiterchip von einem Gehäuse und/oder einer Umhüllung eines optoelektronischen Bauelements umfasst und das optoelektronische Bauelement ist an der flexiblen Leiterplatte befestigt.

Bei einer weiteren Ausgestaltung sind die erste Gruppe von Lichtquellen und die zweite Gruppe von Lichtquellen um einen Winkel α gegeneinander verdreht. Bei dieser Ausgestaltung weisen die erste und die zweite Gruppe zweckmäßigerweise jeweils mindestens eine erste und eine zweite Lichtquelle auf. Insbesondere sind die erste und die zweite Gruppe von Lichtquellen gleichartig ausgebildet. Der Winkel α ist dann durch den Winkel gegeben, den die Richtungen des lateralen Abstandsvektors der ersten zur zweiten Lichtquelle der ersten Gruppe und des lateralen Abstandsvektors der ersten zur zweiten Lichtquelle der zweiten Gruppe einschließen.

Bei einer Ausgestaltung ist die zweite Gruppe von Lichtquellen um den Winkel α verdreht gegenüber der ersten Gruppe von Lichtquellen auf der flexiblen Leiterplatte befestigt. Alternativ oder zusätzlich kann die flexible Leiterplatte zwischen der ersten und der zweiten Gruppe von Lichtquellen - insbesondere im Bereich der Pufferzone - eine Faltung und/oder Biegung aufweisen, mittels der die erste und die zweite Gruppe von Lichtquellen gegeneinander verdreht sind. Insbesondere ist die Biegung und/oder Faltung so ausgeführt, dass die in einem ersten Abschnitt des Lichtmoduls, welcher die erste Gruppe von Lichtquellen enthält, und in einem zweiten Abschnitt des Lichtmoduls, welcher die zweite Gruppe von Lichtquellen enthält, enthaltenen Teilstücke der flexiblen Leiterplatte parallel zu einer gemeinsamen Ebene, zum Beispiel zu einer Hauptfläche des Trägers, verlaufen.

Bei einer Ausgestaltung hat die flexible Leiterplatte die Form eines Streifens mit einer im gestreckten Zustand der flexiblen Leiterplatte geraden Kante. Die Kante verläuft im Bereich der ersten Gruppe von Lichtquellen in einer ersten Richtung, weist im Bereich der Biegung beziehungsweise Faltung der flexiblen Leiterplatte mindestens eine Biegung und/oder einen Knick auf und verläuft im Bereich der zweiten Gruppe von Lichtquellen in einer zweiten Richtung. Die erste und die zweite Richtung schließen einen Winkel β miteinander ein. Bei einer Weiterbildung sind die erste und zweite Gruppe von Lichtquellen in gleicher Ausrichtung auf dem Streifen befestigt und der Winkel β und der Winkel α sind gleich groß.

Bei einer weiteren Ausgestaltung der Beleuchtungseinrichtung weist diese eine reflektierende Folie oder Platte auf, welche den Träger und/oder das Lichtmodul zumindest stellenweise überdeckt. Beispielsweise ist die reflektierende Folie oder Platte an einer Vorderseite des Trägers angeordnet und überdeckt diesen praktisch vollständig. Sie weist Öffnungen auf, durch welche die Lichtquellen der ersten und zweiten Gruppe von Lichtquellen insbesondere hindurch ragen oder zumindest hindurch strahlen.

Eine Hinterleuchtungsvorrichtung gemäß der Erfindung weist eine Beleuchtungseinrichtung gemäß zumindest einer der vorstehend beschriebenen Ausgestaltungen auf. Beispielsweise handelt es sich um eine Hinterleuchtungsvorrichtung für eine Anzeigevorrichtung.

Eine Anzeigevorrichtung gemäß der Erfindung weist mindestens eine Hinterleuchtungsvorrichtung mit einer Beleuchtungseinrichtung gemäß zumindest einer der vorstehend beschriebenen Ausgestaltungen auf.

Bei einer Ausgestaltung weist die Anzeigevorrichtung eine bildgebende Anzeigeeinheit auf, welche von der Beleuchtungseinrichtung im Betrieb hinterleuchtet, insbesondere direkt hinterleuchtet wird. Beispielsweise enthält die bildgebende Anzeigeeinheit ein LCD-Panel (LCD - liquid crystal display), also ein Anzeigefeld auf Basis von Flüssigkristall-Zellen mit einer Mehrzahl von Bildpunkten. Beispielsweise stellt die Anzeigevorrichtung einen LCD-Fernseher dar.

Weitere Ausgestaltungen und Weiterbildungen der Beleuchtungseinrichtung und der Hinterleuchtungsvorrichtung sind im Folgenden in Verbindung mit den Figuren 1A bis 5 beschrieben. Es zeigen:
- Figur 1A: eine schematische perspektivische Ansicht eines Ausschnitts einer Beleuchtungseinrichtung gemäß einem ersten Ausführungsbeispiel,
- Figur 1B: eine schematische Schnittdarstellung eines Ausschnitts der Beleuchtungseinrichtung gemäß dem ersten Ausführungsbeispiel,
- Figur 2A: eine schematische Schnittdarstellung einer Beleuchtungseinrichtung gemäß einem zweiten Ausführungsbeispiel,
- Figur 2B: eine schematische Explosionsdarstellung der Beleuchtungseinrichtung gemäß dem zweiten Ausführungsbeispiel,
- Figur 3: eine schematische Draufsicht auf ein Lichtmodul gemäß einem weiteren Ausführungsbeispiel,
- Figur 4: eine schematische perspektivische Ansicht einer Gruppe von Lichtquellen der Beleuchtungseinrichtung gemäß dem zweiten Ausführungsbeispiel, und
- Figur 5: eine schematische perspektivische Ansicht eines Ausführungsbeispiels einer Hinterleuchtungsvorrichtung.

In den Ausführungsbeispielen und Figuren sind gleiche oder gleich wirkende Bestandteile mit den gleichen Bezugszeichen versehen. Die Figuren und die Größenverhältnisse der in den Figuren dargestellten Elemente sind grundsätzlich nicht als maßstabsgetreu zu betrachten. Vielmehr können einzelne Elemente zur besseren Darstellbarkeit und/oder zum besseren Verständnis übertrieben groß und/oder dick dargestellt sein.

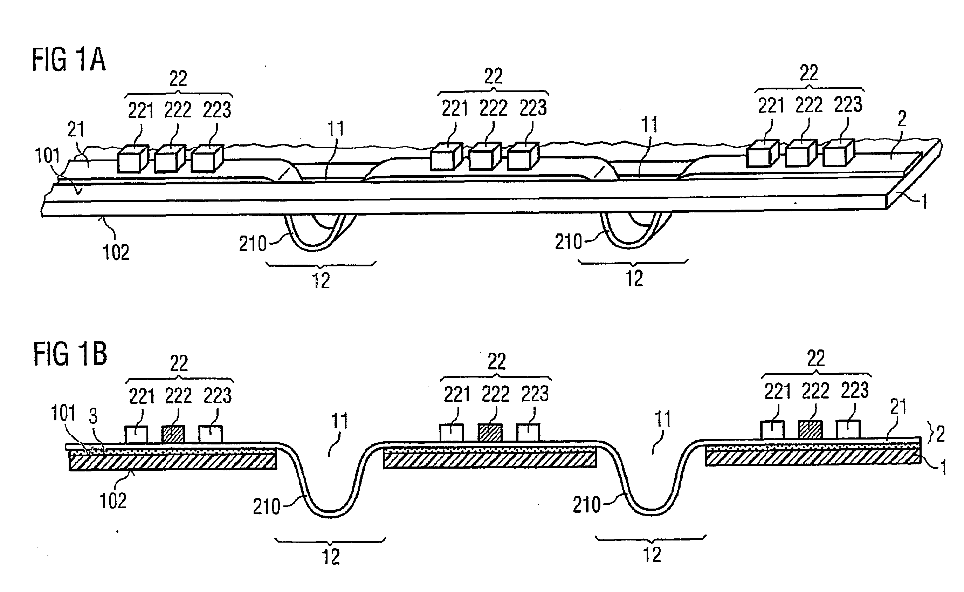

Figur 1A zeigt eine schematische perspektivische Ansicht eines Ausschnitts einer Beleuchtungseinrichtung gemäß einem ersten Ausführungsbeispiel. Figur 1B zeigt eine schematische Schnittdarstellung dieses Ausschnitts.

Die Beleuchtungseinrichtung weist einen Träger 1 auf. Weiter weist die Beleuchtungseinrichtung ein Lichtmodul 2 auf, das eine flexible Leiterplatte 21 enthält. Die flexible Leiterplatte 21 ist vorliegend streifenförmig ausgeführt. Unter einer streifenförmigen Ausführung wird im vorliegenden Zusammenhang verstanden, dass die Länge der flexiblen Leiterplatte 21 größer ist als ihre Breite. Vorzugsweise ist die Länge im gestreckten Zustand der flexiblen Leiterplatte 21 mindestens 2-mal, besonders bevorzugt mindestens 10-mal so groß wie die Breite.

Die flexible leiterplatte 21 enthält beispielsweise einen Grundkörper, der aus einem elektrisch isolierenden Material gebildet ist. Beispielsweise enthält der Grundkörper mindestens eines der folgenden Materialien Polyimid, Pethylennaphtalat, Polyethylen oder besteht daraus. Auf den elektrisch isolierenden Grundkörper sind elektrische Leiterbahnen strukturiert. Beispielsweise sind die Leiterbahnen auf den elektrisch isolierenden Grundkörper aufgedruckt.

Auf der flexiblen Leiterplatte 21 sind mehrere Licht emittierende Halbleiterchips 221, 222, 223 als Lichtquellen befestigt. Die Licht emittierenden Halbleiterchips sind vorliegend direkt mit den Leiterbahnen der flexiblen Leiterplatte 21 mechanisch befestigt und elektrisch kontaktiert. Die flexible Leiterplatte 21 wird zur Befestigung der Licht emittierenden Halbleiterchips 221, 222, 223 vorzugsweise von einer Rolle abgerollt und nach dem Befestigen der Licht emittierenden Halbleiterchips 221, 222, 223 wieder auf eine Rolle aufgerollt. Anders ausdrückt wird die flexible Leiterplatte 21 in einem "Rolle-zu-Rolle"-Prozess mit den Lichtquellen bestückt. Dies erlaubt eine besonders einfache Herstellung und Handhabung des Lichtmoduls.

Die Licht emittierenden Halbleiterchips 221, 222, 223 sind auf der flexiblen Leiterplatte 21 zu Gruppen 22 von Lichtquellen zusammengefasst. Die Gruppen von Lichtquellen 22 sind in einer Reihe auf der streifenförmigen flexiblen Leiterplatte 21 angeordnet und folgen vorliegend in Längsrichtung des Streifens aufeinander. Die lateralen Abstände der Lichtquellen innerhalb einer Gruppe 22 sind zweckmäßigerweise kleiner als der laterale Abstand zweier benachbarter Gruppen 22 von Lichtquellen des Lichtmoduls 2. Vorzugsweise ist der Abstand zweier benachbarter Gruppen 22 von Lichtquellen des Lichtmoduls 2, insbesondere im gestreckten Zustand der flexiblen Leiterplatte 21, doppelt so groß, besonders bevorzugt 5-mal so groß, wie der Abstand zweier benachbarter Lichtquellen 221, 222 beziehungsweise 222, 223 innerhalb einer Gruppe 22.

Jede Gruppe 22 weist bei dem Lichtmodul 2 gemäß dem ersten Ausführungsbeispiel einen rotes Licht emittierenden Halbleiterchip 221, einen grünes Licht emittierenden Halbleiterchip 222 und einen blaues Licht emittierenden Halbleiterchip 223 auf.

Bei einer Ausgestaltung weist das Lichtmodul eine Steuervorrichtung auf, die dazu vorgesehen ist, die Lichtquellen des Lichtmoduls 2 anzusteuern. Die Steuervorrichtung (in den Figuren nicht gezeigt) kann beispielsweise ebenfalls auf der flexiblen Leiterplatte 21 angeordnet sein. Bei einer Weiterbildung ist die Steuervorrichtung dazu vorgesehen, die Lichtquellen 221, 222, 223, oder zumindest die Gruppen 22 von Lichtquellen einzeln anzusteuern. Bei einer anderen Weiterbildung ist die Steuervorrichtung zudem dazu vorgesehen, den Betriebsstrom der Lichtquellen 221, 222, 223 in Abhängigkeit von Messwerten wie der Intensität und/oder dem Farbort des von den Lichtquellen 221, 222, 223 im Betrieb der Beleuchtungseinrichtung emittierten Lichts zu regeln. Dazu kann auf der flexiblen Leiterplatte 21 beispielsweise mindestens ein Sensor wie etwa eine Fotodiode (in den Figuren nicht gezeigt) angeordnet sein.

Zwischen einer ersten und einer zweiten Gruppe 22 von Lichtquellen, vorliegend zwischen je zwei benachbarten Gruppen 22 von Lichtquellen des Lichtmoduls 2, weist die Beleuchtungseinrichtung eine Pufferzone 12 auf. Der Träger 1 weist in jeder Pufferzone 12 eine Öffnung 11 auf. Die Pufferzonen 12 mit den Öffnungen 11 überlappen lateral mit der flexiblen Leiterplatte 21 des Lichtmoduls 2.

Die Gruppen von Lichtquellen 22 sind an einer Vorderseite 101 des Trägers 1 angeordnet. Die flexible Leiterplatte 21 verläuft zwischen den beiden benachbarten Gruppen von Lichtquellen 22 durch die Öffnung 11 hindurch von der Vorderseite 101 zu einer der Vorderseite gegenüberliegenden Rückseite 102 des Trägers 1. Sie weist im Bereich der Öffnung 11 eine U-förmige Biegung 210 auf. Mittels der U-förmigen Biegung 210 des flexiblen Trägers 21 ist der laterale Abstand der Gruppen 22 von Lichtquellen über einen weiten Bereich einstellbar. Verschiedene Träger 1, deren Montagepositionen für die Gruppen 22 von Lichtquellen und/oder deren Öffnungen 11 unterschiedliche Abstände haben, können mit dem gleichen Lichtmodul verwendet werden. Auf diese Weise ist das Lichtmodul 2 besonders flexibel einsetzbar, wodurch eine kostengünstige Herstellung der Beleuchtungseinrichtung erzielt wird.

Bei dem vorliegenden Ausführungsbeispiel ist das Lichtmodul 2 mittels eines doppelseitigen Klebebands 3 an dem Träger 1 befestigt. Genauer ist eine von den Lichtquellen abgewandte Fläche der flexiblen Leiterplatte 21 stellenweise mittels des doppelseitigen Klebebands 3 auf einer vorderseitigen Hauptfläche des Trägers 1 aufgeklebt. Alternativ kann die flexible Leiterplatte 21 selbst in Art eines Klebebandes an ihrer von den Lichtquellen 221, 222, 223 abgewandten Seite mit einer Klebstoffschicht versehen sein. Als weitere Alternative ist ein Auflaminieren der flexiblen Leiterplatte 21 auf den Träger 1 denkbar.

Die Beleuchtungseinrichtung weist bei einer Weiterbildung des ersten Ausführungsbeispiels mindestens ein weiteres Lichtmodul 2 auf, das insbesondere zumindest stellenweise parallel zu dem ersten Lichtmodul 2 verläuft. Die Beleuchtungseinrichtung ist im Bereich des weiteren Lichtmoduls 2 vorzugsweise analog zu dem in den Figuren 1A und 1B gezeigten Ausschnitt ausgeführt.

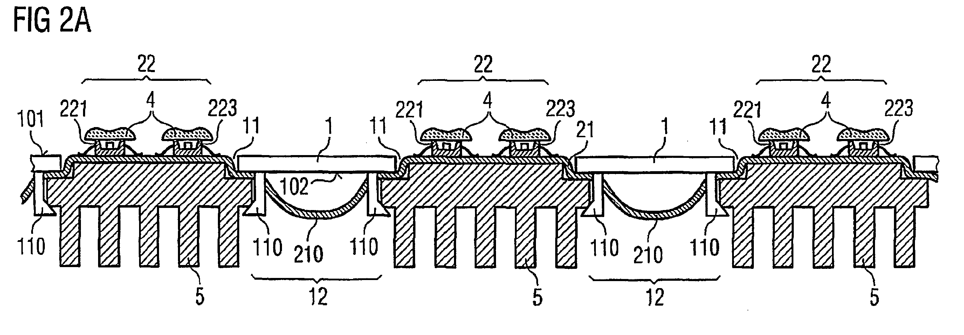

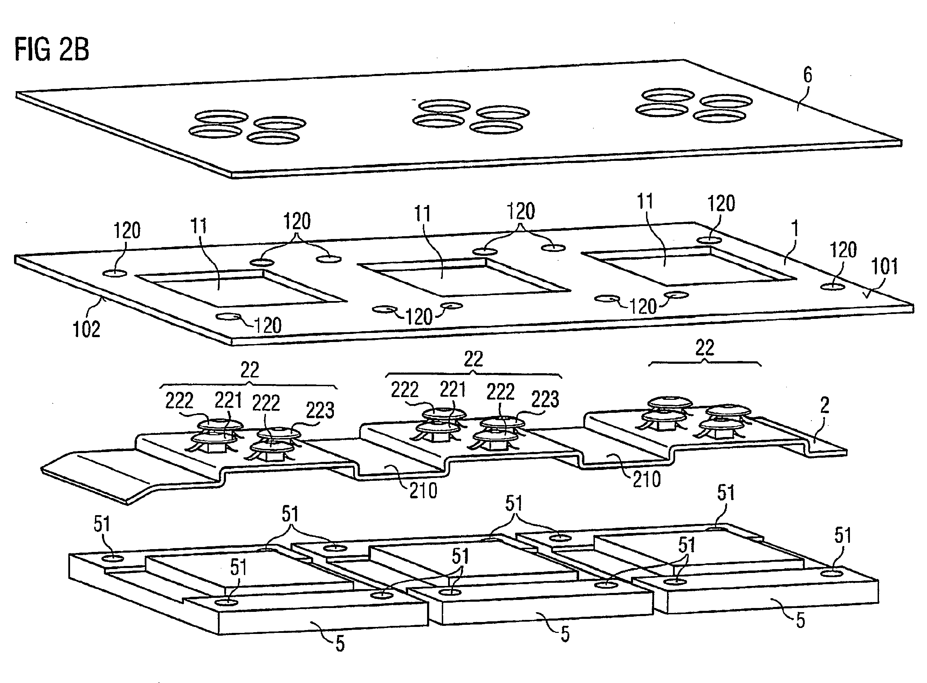

Figuren 2A und 2B zeigen ein zweites Ausführungsbeispiel einer Beleuchtungseinrichtung in einer schematischen Schnittdarstellung und in einer Explosionsdarstellung.

Im Gegensatz zum ersten Ausführungsbeispiel sind beim zweiten Ausführungsbeispiel optoelektronische Bauelemente 221, 222, 223 als Lichtquellen verwendet. Diese enthalten einen Licht emittierenden Halbleiterchip, der vorliegende in einem Gehäuse enthalten und insbesondere mit einer Vergussmasse verkapselt ist. Bei den optoelektronischen Bauelementen 221, 222, 223 handelt es sich vorliegend um oberflächenmontierbare Bauelemente, so genannte SMT-Bauelemente (SMT - surface mounting technology).

Die optoelektronischen Bauelemente 221, 222, 223 weisen vorliegend zudem jeweils eine Linse 4 auf, durch die von dem Halbleiterchip im Betrieb emittiertes Licht aus dem Bauelement ausgekoppelt wird. Beispielsweise weist eine Strahlungsaustrittsfläche der Linse 4 einen konkav gekrümmten Teilbereich auf, durch den eine optische Achse der Linse verläuft. Insbesondere weist die Linse 4 auch einen konvex gekrümmten Teilbereich auf, der den konkav gekrümmten Teilbereich in einem Abstand zur optischen Achse umgibt. Ein optoelektronisches Bauelement mit einer derartigen Linse 4 weist eine Abstrahlcharakteristik auf, bei der die ausgekoppelte Strahlungsleistung bei großen Winkeln zur optischen Achse vorteilhafterweise besonders hoch ist. Auf diese Weise wird mit Vorteil Licht einer Vielzahl von Lichtquellen der Beleuchtungseinrichtung durchmischt und eine homogene Ausleuchtung einer vergleichsweise großen, insbesondere ebenen Fläche durch die Beleuchtungseinrichtung erzielt.

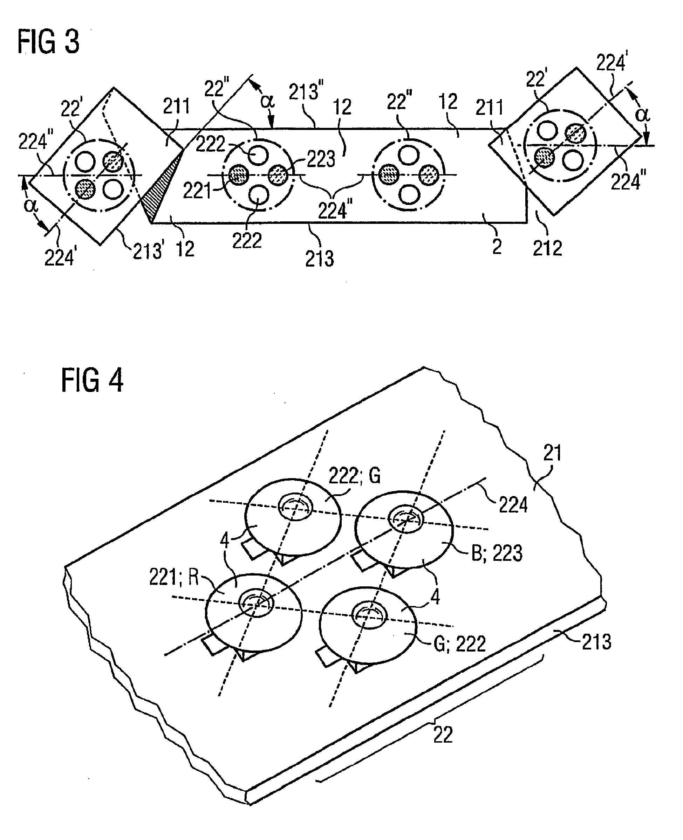

Bei dem vorliegenden Ausführungsbeispiel enthält jede Gruppe 22 von Lichtquellen im Gegensatz zum ersten Ausführungsbeispiel vier Lichtquellen. Figur 4 zeigt eine schematische perspektivische Darstellung einer der Gruppen 22 von Lichtquellen. Die Gruppe 22 enthält eine rotes Licht emittierende Lichtquelle 221 / R, zwei grünes Licht emittierende Lichtquellen 222 / G und eine blaues Licht emittierende Lichtquelle 223 / B. Jede Gruppe 22 von Lichtquellen und somit auch die Beleuchtungseinrichtung ist dazu geeignet, im Betrieb einen Farbeindruck in der Nähe des Weißpunkts im CIE-Normvalenzdiagramm zu erzeugen.

Ein weiterer Unterschied zum ersten Ausführungsbeispiel ist, dass vorliegend jede Gruppe 22 von Lichtquellen in Draufsicht auf die Vorderseite 101 des Trägers 1 in einer Öffnung 11 des Trägers 1 angeordnet ist. Jede Gruppen von Lichtquellen 22 wird vorliegend von einem Kühlkörper 5 in der Öffnung 11 arretiert. Beispielsweise handelt es sich bei dem Kühlkörper 5 um einen metallischen Körper, zum Beispiel weist der Kühlkörper 5 Aluminium auf oder besteht daraus.

Der Kühlkörper weist zweckmäßigerweise eine der Gruppe von Leuchtdioden 22 benachbarte Fläche auf, die insbesondere direkt an die flexible Leiterplatte 21 angrenzt oder auf der die flexible Leiterplatte 21 beispielsweise mit einer Klebstoffschicht oder einem doppelseitigen Klebeband 3 befestigt ist. Die der Gruppe 22 von Lichtquellen zugewandte Seite des Kühlkörpers 5 weist vorzugsweise eine ebene Fläche auf, an der die flexible Leiterplatte 21 befestigt ist oder an die die flexible Leiterplatte 21 angrenzt. So wird eine gute thermische Ankopplung erzielt. Die der Gruppe 22 von Lichtquellen zugewandte Seite des Kühlkörpers kann, beispielsweise in einem Randbereich, wie bei dem vorliegenden Ausführungsbeispiel zudem eine oder mehrere Aussparungen aufweisen, in der/denen die flexible Leiterplatte 21 verläuft. Auf der von der Gruppe 22 von Lichtquellen abgewandten Seite weist der Kühlkörper 5 bei vorliegend Vorsprünge, beispielsweise lamellenartige Vorsprünge auf, mittels derer eine besonders effiziente Dissipation von Verlustwärme erzielt wird.

Das Lichtmodul 2 ragt vorzugsweise von der Rückseite 102 des Trägers 1 her in die Öffnung 11 hinein oder verläuft besonders bevorzugt von der Rückseite 102 durch die Öffnung 11 hindurch zur Vorderseite 101. Insbesondere ragen die Lichtquellen 221, 222, 223 über die vorderseitige Hauptfläche 101 des Trägers 1 hinaus. Beispielsweise wird bei einer Herstellung der Beleuchtungseinrichtung der flexible Träger 21 mittels des Kühlkörpers 5 in die Öffnung hinein oder durch diese hindurchgedrückt.

Die Arretierung erfolgt beispielsweise mittels Halteelementen 110, die zum Beispiel an der Rückseite 102 des Trägers 1 ausgebildet sind. Bei einer Ausgestaltung ist mittels der Halteelemente 110 eine so genannte Schnapp- oder Clip-Verbindung hergestellt, bei der die flexiblen Halteelemente 110 mit dem Kühlkörper verhaken. Dies ist beispielhaft in Figur 2A gezeigt. In Figur 2B ist eine alternative Ausgestaltung gezeigt, bei der der Träger 1 Bohrungen 120 aufweist und der Kühlkörper 5 Gewindebohrungen 51 aufweist oder umgekehrt. Bei dieser Ausgestaltung wird dementsprechend zweckmäßigerweise eine Schraubverbindung zwischen dem Träger 1 und dem Kühlkörper 5 hergestellt.

Bei einer vorteilhaften Weiterbildung ist die Öffnung 11 des Trägers 1 mittels des Kühlkörpers 5 staubdicht verschlossen. Beispielsweise ist hierzu zwischen dem Träger 1 und einem Randbereich des Kühlkörpers 5 eine Gummidichtung angeordnet (in den Figuren nicht gezeigt), die von dem Kühlkörper im montierten Zustand an den Träger und/oder an die flexible Leiterplatte 21 angepresst ist.

Zwischen je zwei benachbarten Gruppen 22 von Lichtquellen weist die Beleuchtungseinrichtung eine Pufferzone 12 auf, die mit dem Lichtmodul 2 überlappt. Anders ausgedrückt verläuft die flexible Leiterplatte 21 in der Pufferzone 12 an der Rückseite 102 des Trägers 1. Sie bildet dort eine U-förmige Biegung 210 aus, sodass das Lichtmodul, wie beim ersten Ausführungsbeispiel, für Beleuchtungseinrichtungen mit verschiedenen Abständen zwischen benachbarten Gruppen 22 von Lichtquellen geeignet ist. Die flexible Leiterplatte 21 behindert die Wärmeabfuhr von Kühlkörpern 5 an der Rückseite 102 des Trägers mit Vorteil nicht oder nur geringfügig.

Bei der Beleuchtungseinrichtung gemäß dem zweiten Ausführungsbeispiel ist an der Vorderseite 101 des Trägers eine reflektierende Folie 6 angeordnet, wie in Figur 2B gezeigt. In Figur 2A ist die reflektierende Folie 6 zur vereinfachten Darstellung weggelassen.

Die reflektierende Folie 6 bedeckt vorliegend die vorderseitige Hauptfläche des Trägers 1 vollständig oder zumindest praktisch vollständig. In Draufsicht auf die Vorderseite 101 des Trägers 1 bedeckt die reflektierende Folie 6 auch die flexible Leiterplatte 21 stellenweise. Für jede der Lichtquellen 221, 222, 223 weist die reflektierende Folie 6 eine Öffnung auf, durch welche die Lichtquelle 221, 222, 223 hindurchragt. Die reflektierende Folie 6 ist zweckmäßigerweise zumindest an ihrer von dem Träger 1 abgewandten Seite diffus reflektierend oder spiegelnd ausgeführt.

In Figur 3 ist eine schematische Draufsicht auf ein Lichtmodul 2 dargestellt, wie es in dem zweiten Ausführungsbeispiel verwendet ist. Das Lichtmodul 2 weist vorliegend erste Gruppen 22' von Lichtquellen auf, die gegen zweite Gruppen 22'' verdreht sind.

Alle Gruppen 22', 22'' von Lichtquellen sind bei dem Ausführungsbeispiel der Figur 3 in gleicher Orientierung auf der flexiblen Leiterplatte 21 montiert. Insbesondere ist die Richtung des lateralen Abstandsvektors zwischen der roten Lichtquelle 221 und der blauen Lichtquelle 223 parallel zu den Kanten 213 der flexiblen Leiterplatte 21. Diese Richtung ist in Figur 3 durch die Linie 224' beziehungsweise 224'' und in Figur durch die Linie 224 markiert. Die Kanten 213 verlaufen im gestreckten Zustand der streifenförmigen flexiblen Leiterplatte 21 parallel zueinander in Längsrichtung des Streifens.

Zwischen einer ersten Gruppe von Lichtquellen 22' und einer zweiten Gruppe von Lichtquellen 22'' weist die flexible Leiterplatte 21 eine Faltung 211 auf, wie im linken Bereich der Figur 3 beispielhaft dargestellt. Alternativ kann sie einen Einschnitt 212 und eine Biegung oder Faltung 211 aufweisen, wie im rechten Bereich der Figur 3 beispielhaft dargestellt. Auf diese Weise ist die erste Gruppe 23' von Lichtquellen gegenüber der, insbesondere benachbarten, zweiten Gruppe 22'' von Lichtquellen um einen Winkel α verdreht. Teilstücke der flexiblen Leiterplatte 21, auf denen die erste beziehungsweise die zweite Gruppe 22', 22'' angeordnet sind, verlaufen bevorzugt parallel zu einer gemeinsamen Ebene. Mit anderen Worten verläuft die flexible Leiterplatte 21 bis auf die Faltung und/oder Biegung 211 zwischen der ersten und der zweiten Gruppe 22', 22'' und die in Figur 3 nicht dargestellten U-förmigen Biegungen 210 vorzugsweise flach.

Der Winkel α ist beispielsweise durch den Winkel zwischen den Richtungen 224' und 224'' gegeben. Da vorliegend die ersten und zweiten Gruppen 22', 22'' von Lichtquellen in der gleichen Ausrichtung auf der flexiblen Leiterplatte 21 montiert sind und die Leiterplatte 21 einen geraden Streifen darstellt, schließen auch die Richtung der Kanten 213' des Teilstücks der flexiblen Leiterplatte 21, auf dem die erste Gruppe 22' von Leuchtdioden angeordnet ist, und der Kanten 213'' des Teilstücks der flexiblen Leiterplatte, auf dem die zweite Gruppe 22'' von Leuchtdioden angeordnet ist, den Winkel α ein. Der Winkel α beträgt beispielsweise 45, 60 oder 90°.

Mit einer verdrehten ersten Gruppe 22' von Lichtquellen wird beispielsweise die Abstrahlcharakteristik in einem Randbereich der Beleuchtungseinrichtung verändert. Dies kann zum Beispiel zweckmäßig sein, um die Homogenität in Randbereichen einer Hinterleuchtungsvorrichtung zu erhöhen, wie unten näher ausgeführt.

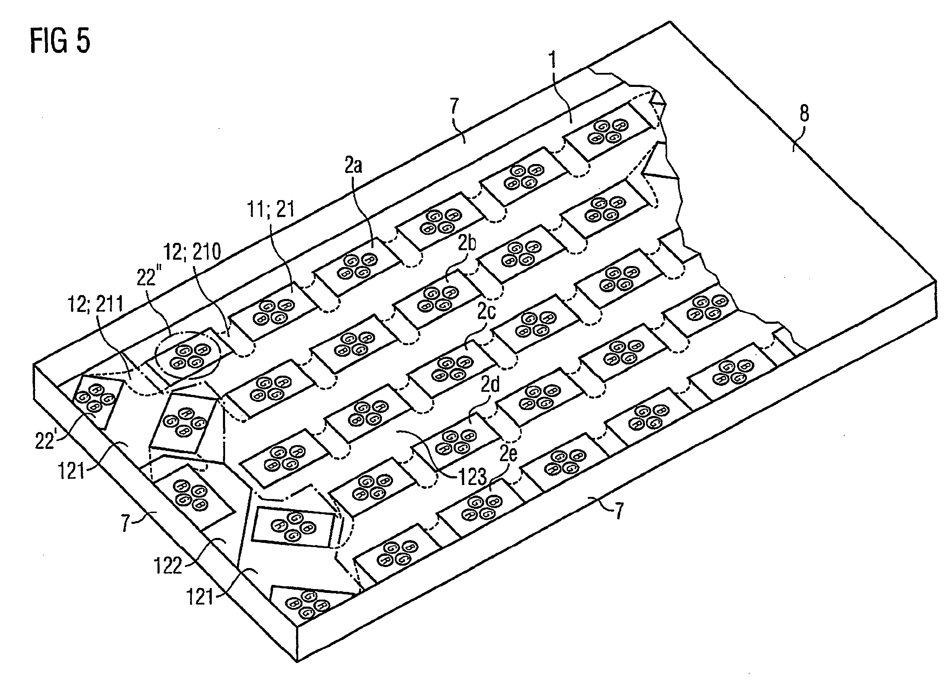

Figur 5 zeigt ein Ausführungsbeispiel einer Hinterleuchtungsvorrichtung. Die Hinterleuchtungsvorrichtung weist eine Beleuchtungseinrichtung auf, die analog zu dem vorstehend beschriebenen zweiten Ausführungsbeispiel der Beleuchtungseinrichtung ausgeführt ist. Im Unterschied zu diesem Ausführungsbeispiel weist die Beleuchtungseinrichtung vorliegend jedoch eine Mehrzahl von Lichtmodulen 2a, 2b, 2c, 2d und 2e auf.

Die Hinterleuchtungsvorrichtung gemäß dem Ausführungsbeispiel der Figur 5 weist zusätzlich zu dem Träger 1, der vorliegend eine Rückwand der Hinterleuchtungsvorrichtung darstellt, umlaufende Seitenwände 7 und eine lichtdurchlässige Platte 8 auf, die in Figur 5 aufgeschnitten dargestellt ist. Zusammen mit dem Träger 1 und den Seitenwänden 7 begrenzt die lichtdurchlässige Platte 8 einen Innenraum der Hinterleuchtungsvorrichtung. Beispielsweise handelt es sich um eine milchigweiße Platte oder eine Diffusorplatte, die etwa aus Kunststoff gebildet ist. Alternativ kann die lichtdurchlässige Platte 8 auch transparent sein. Sie kann strukturiert und/oder bedruckt sein, um das Licht der Lichtquellen 221, 222, 223 zu streuen.

Die Lichtmodule sind so ausgerichtet, dass sie in einem Mittelbereich 123 des Trägers 1 parallel zueinander verlaufen. Mit anderen Worten sind die streifenförmigen flexiblen Leiterplatten 21 der Lichtmodule 2a, 2b, 2c, 2d, 2e in Draufsicht auf die Vorderseite 101 des Trägers in dem Mittelbereich 123 parallel zueinander ausgerichtet.

Wie im Ausführungsbeispiel der Figur 3 dargestellt, sind in Eckbereichen 121, und Randbereichen 122 des Trägers 1 Gruppen 22 von Lichtquellen gegenüber den im Mittelbereich 123 des Trägers 1 angeordneten Gruppen 22 von Lichtquellen um einen Winkel α verdreht. Beispielsweise sind die in den Eckbereichen 121 angeordneten Gruppen 22 um α = 45° gegenüber den im Mittelbereich 123 angeordneten Gruppen 22 verdreht, und in einem zwischen zwei Eckbereichen 121 angeordneten Randbereich 122 angeordneten Gruppen sind um α = 90° gegenüber den im Mittelbereich 123 angeordneten Gruppen verdreht. Vorliegend enthält der Randbereich nur eine Gruppe 22 von Lichtquellen. Bei einer alternativen Ausgestaltung weist die Beleuchtungseinrichtung keinen Randbereich 122 auf, in dem die Gruppen 22 von Lichtquellen um 90° gegenüber den im Mittelbereich 123 angeordneten Gruppen 22 verdreht sind.

Beispielsweise ist bei dem ersten Lichtmodul 2a die erste Gruppe 22' in einem der Eckbereiche 121 gegenüber der nachfolgenden Gruppen 22'', die im Mittelbereich 123 angeordnet ist, um einen Winkel α von beispielsweise 45° verdreht. Vorliegend ist auch die letzte Gruppe an dem der ersten Gruppe 22' gegenüberliegenden Ende des Lichtmoduls 2a um 45° gegen die ihr benachbarte Gruppe 22, die vorliegend im Mittelbereich 123 des Trägers 1 angeordnet ist, verdreht.

Bei dem zweiten Lichtmodul 2b ist beispielsweise die erste Gruppe 22 von Lichtquellen im mittleren Randbereich 122 angeordnet und somit vorliegend um einen Winkel von 90° gegenüber den im Mittelbereich 123 angeordneten Gruppen 22 verdreht. Eine weitere Gruppe 22 von Lichtquellen, beispielsweise die auf die erste Gruppe 22 folgende Gruppe 22 ist in einem der Eckbereiche 121 angeordnet und gegenüber den im Mittelbereich angeordneten Gruppen 22 um einen Winkel von beispielsweise 45° verdreht.

Zum Beispiel die Gruppen 22 von Lichtquellen des dritten Lichtmoduls 2c weisen vorliegend alle die gleiche Orientierung auf.

Die Anordnung der Lichtquellen, Gruppen von Lichtquellen und der Lichtmodule ist jedoch selbstverständlich nicht durch die in Figur 5 dargestellte Anordnung auf diese beschränkt.

Mittels der in den Eck- und Randbereichen 121, 122 angeordneten Gruppen 22 von Lichtquellen wird in diesen Bereichen 121, 122 eine besonders homogene Hinterleuchtung der zu beleuchtenden Fläche erzielt. Die Hinterleuchtungsvorrichtung macht sich dabei die Idee zunutze, dass mittels der verdrehten Gruppen von Lichtquellen 22, 22' in den Randbereichen beziehungsweise Eckbereichen 121, 122 Licht jeder Farbe mit möglichst geringer Abschattung durch andere Lichtquellen den Rand - insbesondere die Seitenflächen 7 - ausleuchtet.

Die Gruppen 22 von Lichtquellen sind bei einer bevorzugten Ausgestaltung zumindest in dem Mittelbereich 123 an den Gitterpunkten eines gedachten Gitters angeordnet. Beispielsweise kann es sich um ein hexagonales oder rechteckiges Gitter handeln. Ausführungsbeispiele zur Anordnung von Lichtquellen und Gruppen von Lichtquellen in einer Beleuchtungseinrichtung beziehungsweise Hinterleuchtungsvorrichtung sind in der Druckschrift WO 2006/076899 A2 enthalten, deren Offenbarungsgehalt insofern hiermit durch Rückbezug aufgenommen ist.

Die Hinterleuchtungsvorrichtung ist beispielsweise als Hinterleuchtungsvorrichtung für eine Anzeigevorrichtung wie einen LCD-Fernseher geeignet.

Die Erfindung ist nicht durch die Beschreibung anhand der Ausführungsbeispiele auf diese beschränkt. Vielmehr umfasst sie jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Beleuchtungseinrichtung mit einem Lichtmodul (2), das mindestens eine erste Gruppe (22, 22') von Lichtquellen (221, 222, 223) und eine zweite Gruppe (22, 22'') von Lichtquellen aufweist, die voneinander beabstandet auf einer flexiblen Leiterplatte (21) angeordnet sind, und mit einem Träger (1), an dem das Lichtmodul befestigt ist, und einer Pufferzone (12) zwischen der ersten und der zweiten Gruppe von Lichtquellen, welche lateral mit dem Lichtmodul überlappt, **dadurch gekennzeichnet, dass**
- die flexible Leiterplatte (21) im Bereich der Pufferzone (12) eine Biegung und/oder Faltung (210, 211) aufweist, oder
- in Draufsicht auf den Träger (1) die erste Gruppe (22, 22') von Lichtquellen (221, 222, 223) in einer Öffnung (11) des Trägers angeordnet ist.

2. Beleuchtungseinrichtung gemäß Anspruch 1, bei der die flexible Leiterplatte (21), insbesondere an einer Rückseite (102) des Trägers (1), im Bereich der Pufferzone (12) eine U-förmige Biegung (210) aufweist.

3. Beleuchtungseinrichtung gemäß einem der vorhergehenden Ansprüche, die zur Emission von einer Vorderseite (101) des Trägers (1) vorgesehen ist und bei der die flexible Leiterplatte (21) im Bereich der Pufferzone (12) zumindest stellenweise an einer der Vorderseite gegenüberliegenden Rückseite (102) des Trägers verläuft.

4. Beleuchtungseinrichtung gemäß einem der Ansprüche 1 bis 3, bei der die erste und die zweite Gruppe (22, 22', 22'') von Lichtquellen (221, 222, 223) auf einer Vorderseite (101) des Trägers (1) angeordnet sind, der Träger im Bereich der Pufferzone (12) eine Öffnung (11) aufweist und die flexible Leiterplatte (21) durch die Öffnung zu einer der Vorderseite gegenüberliegenden Rückseite (102) des Trägers verläuft.

5. Beleuchtungseinrichtung gemäß Anspruch 1, bei der in Draufsicht auf den Träger (1) die zweite Gruppe (22, 22') von Lichtquellen (221, 222, 223) in einer weiteren Öffnung (11) und die Pufferzone (12) zwischen der Öffnung und der weiteren Öffnung angeordnet ist.

6. Beleuchtungseinrichtung gemäß Anspruch 1, bei der ein Kühlkörper (5) an einer Rückseite (102) des Trägers (1) angeordnet ist, der mit der ersten Gruppe (22, 22') von Lichtquellen (221, 222, 223) und der Öffnung (11) lateral überlappt.

7. Beleuchtungseinrichtung gemäß einem der vorhergehenden Ansprüche, bei der das Lichtmodul (2) mit dem Träger (1) verklebt und/oder verklemmt ist.

8. Beleuchtungseinrichtung gemäß Anspruch 6 und 7, bei der die erste Gruppe (22, 22') von Lichtquellen (221, 222, 223) mittels des Kühlkörpers (5) mit dem Träger (1) arretiert ist.

9. Beleuchtungseinrichtung gemäß einem der vorhergehenden Ansprüche, bei der mindestens eine der Lichtquellen (221, 222, 223) einen lichtemittierenden Halbleiterchip aufweist und bei der der lichtemittierende Halbleiterchip (221, 222, 223) von einem Gehäuse und/oder einer Umhüllung eines optoelektronischen Bauelements umfasst ist und das optoelektronische Bauelement an der flexiblen Leiterplatte befestigt ist.

10. Beleuchtungseinrichtung gemäß einem der vorhergehenden Ansprüche, bei dem die erste Gruppe (22') von Lichtquellen (221, 222, 223) und die zweite Gruppe (22'') von Lichtquellen (221, 222, 223) um einen Winkel α gegeneinander verdreht sind.

11. Beleuchtungseinrichtung gemäß Anspruch 10, bei der die flexible Leiterplatte (21) zwischen der ersten und der zweiten Gruppe von Lichtquellen (22', 22'') die Faltung und/oder Biegung (211) aufweist.

12. Beleuchtungseinrichtung gemäß einem der vorhergehenden Ansprüche, die eine reflektierende Folie oder Platte (6) aufweist, welche den Träger (1) und/oder das Lichtmodul (2) zumindest stellenweise überdeckt.

13. Hinterleuchtungsvorrichtung für eine Anzeigevorrichtung mit einer Beleuchtungseinrichtung gemäß einem der vorhergehenden Ansprüche.

14. Anzeigevorrichtung mit einer Hinterleuchtungsvorrichtung gemäß Anspruch 13.

15. Anzeigevorrichtung gemäß Anspruch 14, die eine bildgebende Anzeigeeinheit, insbesondere ein LCD-Panel, aufweist, welche von der Beleuchtungseinrichtung im Betrieb hinterleuchtet wird.

## Claims

1. Lighting device having a light module (2) that has at least a first group (22, 22') of light sources (221, 222, 223) and a second group (22, 22') of light sources that are arranged at intervals from one another on a flexible printed circuit board (21), and having a support (1), on which the light module is mounted, and a buffer area (12) between the first and second groups of light sources that laterally overlaps the light module,
**characterized in that**
- the flexible printed circuit board (21) has a bend and/or fold (210, 211) in the region of the buffer area (12), or
- in a top view of the support (1) the first group (22, 22') of light sources (221, 222, 223) is arranged in an opening (11) in the support.

2. Lighting device according to Claim 1, in which the flexible printed circuit board (21) has a U-shaped bend (210) in the region of the buffer area (12), particularly on a reverse side (102) of the support (1).

3. Lighting device according to either of the preceding claims, which is provided for emission from a front side (101) of the support (1) and in the case of which the flexible printed circuit board (21) runs, at least in places, on a reverse side (102), which is opposite the front side, of the support in the region of the buffer area (12).

4. Lighting device according to one of Claims 1 to 3, in which the first and second groups (22, 22', 22") of light sources (221, 222, 223) are arranged on a front side (101) of the support (1), the support has an opening (11) in the region of the buffer area (12) and the flexible printed circuit board (21) runs through the opening to a reverse side (102), which is opposite the front side of the support.

5. Lighting device according to Claim 1, in which in a top view of the support (1) the second group (22, 22') of light sources (221, 222, 223) is arranged in a further opening (11) and the buffer area (12) is arranged between the opening and the further opening.

6. Lighting device according to Claim 1, in which a heat sink (5) is arranged on a reverse side (102) of the support (1), said heat sink laterally overlapping the first group (22, 22') of light sources (221, 222, 223) and the opening (11).

7. Lighting device according to one of the preceding claims, in which the light module (2) is cemented and/or wedged onto the support (1).

8. Lighting device according to Claims 6 and 7, in which the first group (22, 22') of light sources (221, 222, 223) is locked onto the support (1) by means of the heat sink (5).

9. Lighting device according to one of the preceding claims, in which at least one of the light sources (221, 222, 223) has a light-emitting semiconductor chip and in which the light-emitting semiconductor chip (221, 222, 223) is comprised by a housing and/or an enclosure for an opto-electronic component and the opto-electronic component is mounted on the flexible printed circuit board.

10. Lighting device according to one of the preceding claims, in which the first group (22') of light sources (221, 222, 223) and the second group (22'') of light sources (221, 222, 223) are rotated relative to one another through an angle α.

11. Lighting device according to Claim 10, in which the flexible printed circuit board (21) has the fold and/or bend (211) between the first and the second group of light sources (22', 22").

12. Lighting device according to one of the preceding claims, which has a reflective film or plate (6) that covers the support (1) and/or the light module (2) at least in places.

13. Backlight apparatus for a display apparatus having a lighting device according to one of the preceding claims.

14. Display apparatus having a backlight apparatus according to Claim 13.

15. Display apparatus according to Claim 14, which has an imaging display unit, particularly an LCD panel, that is backlit by the lighting device during operation.

## Revendications

1. Dispositif d'éclairage comportant un module d'éclairage (2) qui comprend au moins un premier groupe (22, 22') de sources lumineuses (221, 222, 223) et un second groupe (22, 22'') de sources lumineuses, qui sont disposées de manière espacée les unes des autres sur une carte de circuit imprimé flexible (21), et comportant un support (1) sur lequel est fixé le module d'éclairage, et une zone tampon (12) entre les premier et second groupes de sources lumineuses, laquelle zone tampon se chevauche latéralement avec le module d'éclairage, **caractérisé en ce que**
- la carte de circuit imprimé flexible (21) présente dans la région de la zone tampon (12) une courbure et/ou un pli (210, 211), ou
- lorsque le support (1) est vu de dessus, le premier groupe (22, 22') de sources lumineuses (221, 222, 223) est disposé dans une ouverture (11) du support.

2. Dispositif d'éclairage selon la revendication 1, dans lequel la carte de circuit imprimé flexible (21) présente, notamment sur une face arrière (102) du support (1), dans la région de la zone tampon (12), une courbure en forme de U (210).

3. Dispositif d'éclairage selon l'une quelconque des revendications précédentes, qui est prévu pour émettre par une face avant (101) du support (1) et dans lequel la carte de circuit imprimé flexible (21) s'étend dans la région de la zone tampon (12), au moins par endroits sur une face arrière (102) opposée à la face avant du support.

4. Dispositif d'éclairage selon l'une quelconque des revendications 1 à 3, dans lequel les premier et second groupes (22, 22', 22'') de sources lumineuses (221, 222, 223) sont disposés sur une face avant (101) du support (1), le support présente dans la région de la zone tampon (12) une ouverture (11) et la carte de circuit imprimé flexible (21) s'étend à travers l'ouverture jusqu'à une face arrière (102) opposée à la face avant du support.

5. Dispositif d'éclairage selon la revendication 1, dans lequel, lorsque le support (1) est vu de dessus, le second groupe (22, 22') de sources lumineuses (221, 222, 223) est disposé dans une / ouverture supplémentaire (11) et la zone tampon (12) est disposée entre l'ouverture et l'ouverture supplémentaire.

6. Dispositif d'éclairage selon la revendication 1, dans lequel un corps de refroidissement (5) est disposé sur une face arrière (102) du support (1), lequel corps de refroidissement se chevauche latéralement avec le premier groupe (22, 22') de sources lumineuses (221, 222, 223) et l'ouverture (11).

7. Dispositif d'éclairage selon l'une quelconque des revendications précédentes, dans lequel le module d'éclairage (2) est collé et/ou coincé sur le support (1).

8. Dispositif d'éclairage selon les revendications 6 et 7, dans lequel le premier groupe (22, 22'') de sources lumineuses (221, 222, 223) est bloqué avec le support (1) au moyen du corp de refroidissement (5).

9. Dispositif d'éclairage selon l'une quelconque des revendications précédentes, dans lequel au moins l'une des sources lumineuses (221, 222, 223) comporte une puce à semiconducteur émettrice de lumière et dans lequel la puce à semiconducteur émettrice de lumière (221, 222, 223) est contenue dans un boîtier et/ou un enrobage d'un composant optoélectronique et dans lequel le composant optoélectronique est fixé à la carte de circuit imprimé flexible.

10. Dispositif d'éclairage selon l'une quelconque des revendications précédentes, dans lequel le premier groupe (22') de sources lumineuses (221, 222, 223) et le second groupe (22'') de sources lumineuses (221, 222, 223) sont tournés l'un par rapport à l'autre d'un angle α.

11. Dispositif d'éclairage selon la revendication 10, dans lequel la carte de circuit imprimé (21) comporte le pli et/ou la courbure (211) entre les premier et second groupes de sources lumineuses (22', 22'').

12. Dispositif d'éclairage selon l'une quelconque des revendications précédentes, comprenant une feuille ou une plaque (6) réfléchissante qui recouvre au moins par endroits le support (1) et/ou le module d'éclairage (2).

13. Dispositif de rétroéclairage destiné à un dispositif d'affichage comportant un dispositif d'éclairage selon l'une quelconque des revendications précédentes.

14. Dispositif d'affichage comportant un dispositif de rétroéclairage selon la revendication 13.

15. Dispositif d'affichage selon la revendication 14, comprenant une unité d'affichage génératrice d'image, notamment un panneau à cristaux liquides, qui est rétroéclairée par le dispositif d'éclairage lors du fonctionnement.
